(19) Europäisches Patentamt
European Patent Office
Office européen des brevets

(11) **EP 2 791 625 B1**

(12) **EUROPÄISCHE PATENTSCHRIFT**

(45) Veröffentlichungstag und Bekanntmachung des Hinweises auf die Patenterteilung:
**01.03.2017 Patentblatt 2017/09**

(21) Anmeldenummer: **12801710.0**

(22) Anmeldetag: **15.11.2012**

(51) Int Cl.:
**G01D 5/14** (2006.01)   **F16H 59/10** (2006.01)

(86) Internationale Anmeldenummer:
**PCT/EP2012/072666**

(87) Internationale Veröffentlichungsnummer:
**WO 2013/087336 (20.06.2013 Gazette 2013/25)**

(54) **SENSORVORRICHTUNG UND VERFAHREN ZUR POSITIONSERFASSUNG SOWIE MAGNETELEMENT FÜR DIE SENSORVORRICHTUNG**

SENSOR APPARATUS AND METHOD FOR DETECTING A POSITION AND MAGNETIC ELEMENT FOR THE SENSOR APPARATUS

DISPOSITIF CAPTEUR ET PROCÉDÉ DE DÉTECTION DE POSITION, ET ÉLÉMENT MAGNÉTIQUE POUR LE DISPOSITIF CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.12.2011 DE 102011088365**

(43) Veröffentlichungstag der Anmeldung:
**22.10.2014 Patentblatt 2014/43**

(73) Patentinhaber: **ZF Friedrichshafen AG**
**88046 Friedrichshafen (DE)**

(72) Erfinder:
• **PFEIFER, Ralf**
**49356 Diepholz (DE)**
• **PEUKERT, Andreas**
**49406 Barnstorf (DE)**

(56) Entgegenhaltungen:
**EP-A1- 1 942 317    EP-A2- 0 212 628**
**DE-A1- 1 438 899    JP-A- 61 133 819**
**US-A- 5 880 683     US-A- 5 880 913**
**US-B1- 6 404 188**

**Beschreibung**

Die vorliegende Erfindung betrifft eine Sensorvorrichtung, ein Verfahren zur Erfassung einer Position des Magnetelementes in Bezug zu einem Sensorelement und ein Magnetelement für eine solche Sensorvorrichtung gemäß den Hauptansprüchen.

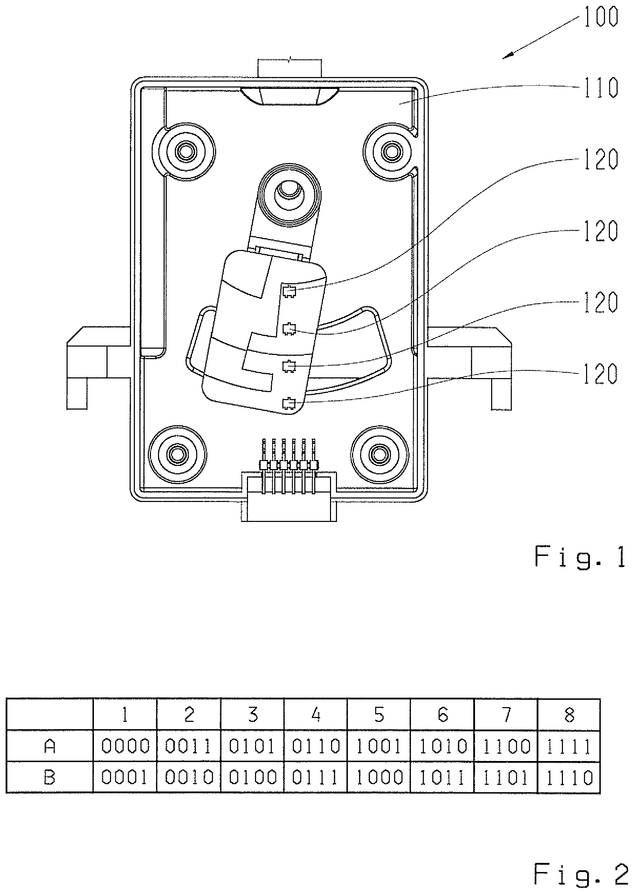

Derzeit wird in einigen Anwendungen für Gangwahlschalter eine Magnetplatte eingesetzt, die vom Wählhebel bewegt und deren Position von Hall-Sensoren erfasst wird, wies es beispielsweise in der Fig. 1 als Beispiel einer Schalthebelsensoranordnung 100 gezeigt ist, die zur Auswertung der Schalthebelstellung eine Magnetplatte 110 aufweist, deren magnetische Bereiche von mehreren Sensoren 120, die insbesondere als Hall-Sensoren ausgestaltet sind, ausgelesen werden. Dabei erkennen die Hall-Sensoren 120 und eine nachgeschaltete Auswertelogik eine Richtung des Magnetfeldes als "1" und die andere als "0", jeder Sensor kann also zwei Werte ausgeben (d. h. als binärer Sensor arbeiten) und diese Werte "0" und "1" werden in der Codierungstheorie als Alphabet bezeichnet. Die beispielhafte Analyse des vorhandenen Produktes, wie beispielsweise die in der Fig. 1 wiedergegebene Anordnung in einer Übersichtsdarstellung und einer Detaildarstellung zeigt, dass sich mit vier Sensoren nun $2^4$ = 16 verschiedene Zustände als 4-Bit-Wort darstellen lassen. Für die Darstellung der verschiedenen Schalthebelstellungen werden aber nur 6 Codeworte benötigt (P R N D + -; P=Parken, R = Rückwärtsgang, N=Neutralstellung, D = Drive = Fahrstellung des Schalthebels, +=Schaltstellung zur Bewirkung einer Schaltung in einen höheren Gang, -= Schaltstellung zur Bewirkung einer Schaltung in einen niedrigeren Gang), theoretisch wären hier also auch drei Sensoren ausreichend.

Um einzelne Bitfehler zu erkennen, werden spezielle Eigenschaften dieser Codewörter verlangt, die sich insbesondere über die Hamming-Distanz messen lassen. Wird beispielsweise eine minimale Hamming-Distanz von zwei verlangt, so sollte jedes Codewort, das für die Ausgabe verwendet wird, sich in mindestens zwei Zeichen von jedem der anderen gültigen Codewörter unterscheiden. Auf das Beispiel aus Fig. 1 angewendet, könnte man eine minimale Hamming-Distanz von drei fordem. Allerdings lassen sich unter den 16 möglichen Codewörtern nicht mehr als jeweils zwei Codewörter finden, die diese Bedingung erfüllen. Da aber sechs Codeworte für die Ausgabe von P, R, N, D, +, - benötigt werden, kann die gezeigte Sensorgruppe die Gangwahl nicht mit einer Hamming-Distanz von $\geq$ 3 ausgeben. Wenn die Anforderung auf eine minimale Hamming-Distanz von zwei reduziert wird, können bis zu acht verschiedene Codewörter kombiniert werden. Die Tabelle aus Fig. 2 zeigt die beiden möglichen Lösungen A oder B, bei denen jedes Codewort zu jedem anderen Codewort in seinem (Codierungs-) Muster 1 bis 8 mindestens den Hamming-Abstand zwei aufweist.

Die Dokumente US 5,880,683 A, JP 61-133819 A und US 6,404,188 B1 offenbaren jeweils eine Sensorvorrichtung nach dem Oberbegriff des Patentanspruchs 1.

Das Dokument DE 14 38 899 A1 offenbart ein Magnetelement für eine Sensorvorrichtung, wobei das Magnetelement eine Mehrzahl von magnetisierten Bereichen und wenigstens einen nicht-magnetisierten Bereich angrenzend zu wenigstens zwei magnetisierten Bereichen umfasst, wobei der nicht-magnetisierte Bereich wenigstens eine Öffnung und/oder Ausnehmung aufweist.

Das Dokument US 5,880,913 A offenbart einen Sensor mit einem zentralen Bereich, welcher von gegenüberliegenden Endbereichen eingefasst ist. Der zentrale Bereich des Sensors weist eine mehrlagige Schichtstruktur auf, welche eine diamagnetische Kupferschicht zwischen einer vormagnetisierten, mehrlagigen Schicht und einer ferromagnetischen Schicht aufweist.

Das Dokument EP 0 212 628 A2 betrifft eine Sensorvorrichtung umfassend mehrere Magnetelemente, welche entlang einer Anordnungsachse zueinander beabstandet angeordnet sind, wobei ein zwischen zwei magnetisierten Bereichen ausgebildeter Zwischenraum einen nicht-magnetisierten Bereich ausmacht.

Die EP 1 003 186 A1 offenbart ein Verfahren, einen Wählschalter und eine Wähleinrichtung zur sicheren Positionserkennung einer von dem Wählschalter eingenommenen Position.

Vor diesem Hintergrund schafft die vorliegende Erfindung eine verbesserte Sensorvorrichtung, ein verbessertes Verfahren zur Erfassung einer Position des Magnetelementes in Bezug zu einem Sensorelement und ein verbessertes Magnetelement für eine Sensorvorrichtung gemäß den Hauptansprüchen. Vorteilhafte Ausgestaltungen ergeben sich aus den Unteransprüchen und der nachfolgenden Beschreibung.

Die vorliegende Erfindung schafft eine Sensorvorrichtung mit zumindest einem Sensorelement, insbesondere einem Hallsensorelement, und zumindest einem in Bezug zum Sensorelement beweglichen Magnetelement, das eine Mehrzahl von unterschiedlich magnetisierten Bereichen aufweist, dadurch gekennzeichnet, dass das Sensorelement ausgebildet ist, um ein Sensorsignal auszugeben, das einen Zustand in Bezug auf eine Magnetisierung eines sich im Messbereich des Sensorelements befindlichen Bereiches des Magnetelementes durch einen von zumindest drei vordefinierten Sensorsignalwerten repräsentiert.

Die vorliegende Erfindung schafft ferner ein Verfahren zur Erfassung einer Position des Magnetelementes in Bezug zu einem Sensorelement, wobei das Verfahren eine vorstehend beschriebene Sensorvorrichtung verwendet, gekennzeichnet durch den folgenden Schritt:

-   Ausgeben eines Sensorsignals, das einen Zustand in Bezug auf eine Magnetisierung eines sich im Messbereich des Sensorelements befindlichen Bereiches des Magnetelementes durch einen von zumindest drei vordefinierten Sensorsignalwerten repräsentiert.

Des Weiteren schafft die vorliegende Erfindung ein Magnetelement für eine Sensorvorrichtung, wobei das Magnetelement eine Mehrzahl von magnetisierten Bereichen und wenigstens einen nicht-magnetisierten und diamagnetischen Bereich angrenzend zu wenigstens zwei magnetisierten Bereichen umfasst. Vorzugsweise ist der nicht-magnetisierte Bereich und diamagnetische Bereich wenigstens angrenzend zu, weiter bevorzugt zwischen zwei identisch magnetisierten und/oder zwischen zwei unterschiedlich magnetisierten Bereichen angeordnet.

Unter einem Sensorelement kann insbesondere ein Sensor verstanden werden, der ausgebildet ist, um magnetische Größen zu erfassen. Beispielsweise kann das Sensorelement ein Hallsensor sein. Unter einem Magnetelement kann ein Element verstanden werden, das unterschiedlich magnetisierte Bereiche aufweist. Zum Beispiel kann das Magnetelement eine Scheibe sein, die in ihrem Körper unterschiedlich magnetisierte Bereiche enthält. Alternativ kann auch das Magnetelement ein Trägerblech aufweisen, auf dem einzelne Magnete befestigt sind. Es sollte sich das Magnetelement jedoch in Relation zum Sensorelement bewegen lassen, um eine Positionsänderung des Magnetelementes (welches beispielsweise mit einem Schalthebel eines Fahrzeuggetriebes verbunden ist) in Bezug zum Sensorelement erfassen zu können. Unter einem Sensorsignal kann ein Ausgabesignal des Sensorelementes verstanden werden, welches eine Information über einen Zustand der Magnetisierung des Magentelementes in einem Bereich aufweist, der in dem Messbereich des Sensorelementes liegt. Unter einen Zustand in Bezug auf eine Magnetisierung kann ein Vorliegen einer Magnetisierung (insbesondere der Orientierung eines Magnetfeldes) oder keiner Magnetisierung des Bereichs des Magnetelementes verstanden werden, der im Messbereich des Sensorelementes liegt. Unter einem vordefinierten Sensorsignalwert kann ein Wert aus einer vordefinierten Menge von Sensorsignalwerten verstanden werden. Insbesondere können die Sensorsignalwerte zumindest drei diskrete Werte annehmen, die beispielsweise das Vorliegen eines Magnetfeldes in eine erste Richtung, eine von der ersten Richtung unterschiedliche zweite Richtung oder das Vorliegen keines Magnetfeldes im Bereich des Magnetelementes im Messbereich des Sensorelementes repräsentiert.

Die vorliegende Erfindung basiert auf der Erkenntnis, dass durch die Verwendung von Sensorsignalen, die Signalwerte aufweisen, die aus zumindest drei Sensorsignalwerten gewählt sind, sehr präzise Aussagen über das Vorliegen eines Zustandes in Bezug auf eine Magnetisierung eines Bereichs des Mangelelementes im Messbereich des Sensorelementes möglich wird. Insbesondere kann hierdurch mit einem einzelnen Sensor eine detailliertere Aussage über den konkreten Zustand des Magnetelementes im Messbereich des Sensorelementes getroffen werden. Gegenüber Lösungen im Stand der Technik, bei denen Sensoren mit binären Sensorsignalwerten verwendet werden, kann vorteilhaft durch die Hinzufügung eines weiteren Sensorsignalwertes, insbesondere der das Vorliegen von keiner Magnetisierung des Magnetelementes im Messbereich des Sensors repräsentiert, eine Erhöhung der Messgenauigkeit bei lediglich geringen Zusatzkosten erreicht werden. Zusätzlich kann auch eine Auswertung von derartigen Sensorsignalen verbessert werden, da beispielsweise bei der Kombination von Sensorsignalen von mehreren solchen Sensorvorrichtungen zu Sensorsignalworten ein größerer Hamming-Abstand zwischen einzelnen Sensorsignalworten realisiert werden kann, als im Falle der Verwendung von Sensoren mit binären Ausgabewerten.

Besonders günstig ist eine Ausführungsform der vorliegenden Erfindung, bei der das Sensorelement ausgebildet ist, um einen vordefinierten Sensorsignalwert als Sensorsignal bereitzustellen, wenn in einem Zustand in Bezug auf eine Magnetisierung des vor dem Sensorelement befindlichen Bereiches des Magnetelementes, kein magnetischer Fluss auf das Sensorelement wirkt. Eine derartige Ausführungsform der vorliegenden Erfindung bietet den Vorteil einer Zusatzinformation im Sensorsignal, dass keine Magnetisierung des Magnetelementes im Messbereich des Sensorelementes vorliegt. Gegenüber herkömmlichen Ansätzen, bei denen keine Erfassung eines Zustandes mit fehlender Magnetisierung möglich ist, kann auf diese Weise eine detailliertere Information über den Zustand der Magnetisierung des Magnetelementes im Messbereich des Sensorelementes erfasst werden.

Auch kann gemäß einer weiteren Ausführungsform der vorliegenden Erfindung das Sensorelement ausgebildet sein, um ein Sensorsignal mit einem Sensorsignalwert bereitzustellen, aus dem die Orientierung eines Magnetfeldes an dem sich im Messbereich des Sensorelementes befindlichen Bereiches des Magnetelementes erkennbar ist, nicht jedoch eine Stärke des Magnetfeldes an dem sich im Messbereich des Sensorelements befindlichen Bereiches des Magnetelementes. Eine derartige Ausführungsform der vorliegenden Erfindung bietet den Vorteil, dass lediglich das Vorzeigen eines erfassten Magnetfeldes als relevant betrachtet wird, wodurch sich die Anzahl von möglichen Signalsensorwerten reduziert, sodass eine Verarbeitung der Sensorsignale vereinfacht wird.

Um eine möglichst aussagekräftige Information über die relative Position des Magnetelementes in Bezug zum Sensorelement zu erhalten, kann die Sensorvorrichtung zumindest ein weiteres Sensorelement, insbesondere ein weiteres Hallsensorelement, aufweisen, wobei das weitere Sensorelement ausgebildet ist, um ein weiteres Sensorsignal auszugeben, das einen Zustand in Bezug auf eine Magnetisierung eines sich im Messbereich des weiteren Sensorelement befindlichen Bereiches des Magnetelementes durch einen von zumindest drei vordefinierten Sensorsignalwerten repräsentiert. Auf dieser Weise kann ein Sensorsignalcodewort aus den Signalwerten des Sensorsignals und des weiteren Sensorsignals ermittelt werden, welches eine zuverlässigere Aussage über die relative Position des Magnetelementes in Bezug zum Sensorelement bietet, als die Information, die alleine in dem Sensorsignalwert eines einzelnen Sensorelementes enthalten ist.

Besonders vorteilhaft ist ferner eine Ausführungsform der vorliegenden Erfindung, bei der eine Signalausgabeeinheit vorgesehen ist, die ausgebildet ist, um den Sensorsignalwert des Sensorsignals des Sensorelementes mit zumindest dem Sensorsignalwert des weiteren Sensorsignals des zumindest einen weiteren Sensorelementes zu einem Sensorsignalwort zu verknüpfen, wobei die Signalausgabeeinheit ferner ausgebildet ist, um für unterschiedliche relative Positionen des Magnetelementes zu einem Sensorsignalwort zu verknüpfen, wobei die Signalausgabeeinheit ferner ausgebildet ist, um für unterschiedliche relative Positionen des Magnetelementes vor dem Sensorelement und dem weiteren Sensorelement Sensorsignalworte auszugeben, die einen Hamming-Abstand von mindestens zwei, insbesondere die einen Hamming-Abstand von mindestens drei aufweisen. Eine derartige Ausführungsform der vorliegenden Erfindung bietet den Vorteil, dass eine Unterscheidbarkeit der einzelnen Sensorsignalworte erhöht werden kann.

Um eine sehr gute Unterscheidbarkeit des Zustandes der Magnetisierung des Magnetfeldes im Messbereich des Sensorelementes zu ermöglichen, ist das Magnetelement besonders ausgestaltet. Das Magnetelement weist zumindest eine Öffnung und/oder Ausnehmung zwischen zwei magnetisierten Bereichen auf, insbesondere wobei die Öffnung und/oder Ausnehmung einen Zustand in Bezug auf eine Magnetisierung eines Bereichs des Magnetelementes repräsentiert, in dem keine Magnetisierung vorliegt. Durch das Vorsehen der Öffnung und/oder der Ausnehmung kann gegenüber Ansätzen im Stand der Technik ein besonders guter und leicht zu erkennender Übergang zwischen zwei unterschiedlich oder identisch magnetisierten Bereichen des Magnetelementes sichergestellt werden.

Eine nochmalige Verbesserung der Unterscheidbarkeit zwischen zwei unterschiedlich oder identisch magnetisierten Bereichen des Magnetelementes wird gemäß der vorliegenden Erfindung realisiert, indem in der Öffnung und/oder Ausnehmung ein diamagnetisches Material, insbesondere Kupfer, angeordnet ist. Die Anordnung eines solchen diamagnetischen Materials ermöglicht das "Herausdrängen" von Magnetfeldlinien in den Bereichen, die das diamagnetische Material aufweisen. Im Fall einer Anordnung eines diamagnetischen Materials im Messbereich des Sensorelementes kann somit das Vorliegen von einem Bereich mit einem nichtmagnetisierten Zustand des Magnetelementes noch besser und eindeutiger erkannt werden.

Um ein besonders einfaches Magnetelement herstellen zu können, kann das Magnetelement mehrere Teileelemente aufweisen, wobei zumindest ein teilweise planares Trägerelement vorgesehen ist, auf dem magnetische Teileelemente angeordnet sind. Ein zumindest teilweise planares Trägerelement kann beispielsweise ein (weiter auf Blatt 7 der ursprünglich eingereichten Unterlagen)

Trägerblech sein, auf das die einzelnen magnetischen Teileelemente aufgebracht oder eingebracht sind. Magnetische Teileelemente können dabei beispielsweise Dauermagnete sein, die auf das planare Trägerelement aufgeklebt oder als separates Element in das planare Trägerelement eingesetzt und mit dem Trägerelement verspannt oder anderweitig unbeweglich verbunden werden.

Gemäß einer vorteilhaften Ausführungsform der vorliegenden Erfindung kann eine Sensorprüfeinheit vorgesehen sein, die ausgebildet ist, um eine Richtung eines Stromflusses durch das Sensorelement zu verändern und auf der Basis eines Sensorsignalwerts eines nach verändertem Stromfluss durch das Sensorelement erfassten Sensorsignals eine korrekte Funktion des Sensorelementes zu erkennen. Eine derartige Ausführungsform der vorliegenden Erfindung bietet den Vorteil, dass die Sensorvorrichtung eine separate interne Funktionsprüfung ermöglicht, so dass eine fehlerhaft arbeitende Sensorvorrichtung mit geringem Aufwand erkannt und schnell ausgetauscht werden kann.

Besonders vorteilhaft kann die vorliegende Erfindung im Zusammenhang mit der Ermittlung einer Schaltstellung eines Schalthebels für die Gangwahl eines Fahrzeugs eingesetzt werden. Gemäß einer besonderen Ausführungsform der vorliegenden Erfindung kann somit eine Schalteinrichtung, insbesondere für ein Kraftfahrzeug vorgesehen sein, wobei eine Sensorvorrichtung verwendet wird, wie sie vorstehend in einer Variante beschrieben wurde, wobei die Sensorvorrichtung ausgebildet ist, um eine Stellung eines Schalthebels, insbesondere eines Gangschalthebels, zu erfassen.

Die Erfindung wird anhand der beigefügten Zeichnungen beispielhaft näher erläutert. Es zeigen:

Fig. 1 ein Beispiel für eine Verwendung einer Sensorvorrichtung gemäß dem Stand der Technik;

Fig. 2 eine Tabelle, die ein binäres Schaltverhalten von Codewörtern aus 4 Sensorsignalwerten mit einem Hamming-Abstand von zwei zeigt.

Fig. 3 ein Blockschaltbild eines Ausführungsbeispiels der vorliegenden Erfindung als Sensorvorrichtung;

Fig. 4A eine schematische Draufsicht eines Magnetelementes gemäß einem Ausführungsbeispiel der vorliegenden Erfindung;

Fig. 4B eine Tabelle, die ein ternäres Schaltverhalten basierend auf Codewörtern aus vier erzeugbaren Sensorsignalwerten des in Fig. 4A gezeigten Ausführungsbeispiels zeigt;

Fig. 5A    eine erste Prinzipskizze zur Verdeutlichung der Entstehung der Hall-Spannung durch ein äußeres Magnetfeld;

Fig. 5B    eine zweite Prinzipskizze zur Verdeutlichung der Entstehung der Hall-Spannung durch ein äußeres Magnetfeld;

Fig. 6    eine Tabelle, die ein Beispielmuster für eine Hammingdistanz $h_{min} = 3$ bei Verwendung eines ternären Sensors wiedergibt;

Fig. 7    eine Tabelle, in der ein Vergleich der Ausbeute von unterschiedlichen Codewörtern bei verschiedenen Sensortypen abgebildet ist;

Fig. 8    eine Tabelle, in der eine Anzahl von Sensoren dargestellt ist, die bei Umbau von binären auf ternäre Sensoren eingespart werden können;

Fig. 9    ein Ablaufdiagramm eines Ausführungsbeispiels der vorliegenden Erfindung als Verfahren.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

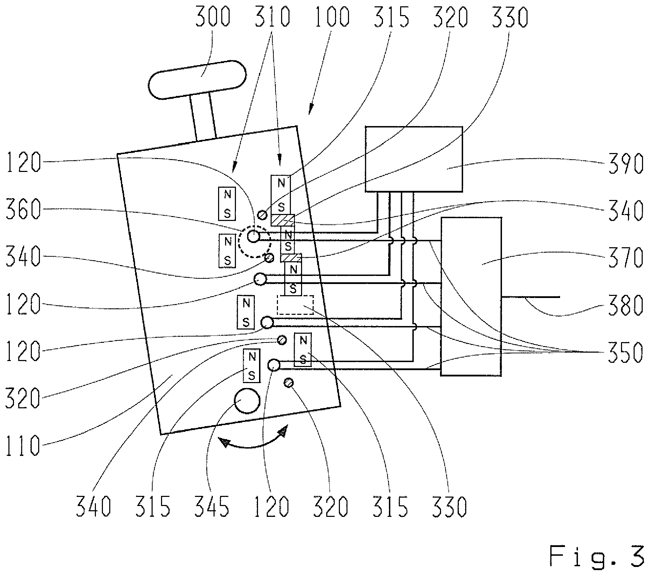

In der Fig. 3 ist ein Blockschaltbild eines Ausführungsbeispiels der vorliegenden Erfindung als Sensorvorrichtung 100 dargestellt. Die Sensorvorrichtung 100 ist beispielsweise an einem Gangwahlhebel 300 eines Automatikgetriebes angeordnet und umfasst zumindest ein Magnetelement 110, auf dem unterschiedlich magnetisierte Bereiche 310 vorhanden sind. Diese unterschiedlich magnetischen Bereiche können beispielsweise durch Dauermagneten 315 gebildet sein, die in das Magnetelement 110 eingebettet oder auf dem Magnetelement 110 aufgeklebt sind. Weiterhin können auch im Magnetelement 110 Löcher 320 und/oder Ausnehmungen 330 (d. h. Vertiefungen in einer Trägerplatte des Magnetelementes 110) eingebracht sein. Alternativ oder zusätzlich kann in diese Löcher 320 und/oder Ausnehmungen 330 ein diamagnetisches Material 340 eingebracht sein, um eine Konzentration des Magnetfeldes auf die nicht mit diamagnetischem Material 340 verfüllten Bereiche des Magnetelementes 110 zu erreichen. Ferner umfasst die Sensorvorrichtung 100 zumindest ein Sensorelement 120, vorliegend vier Sensorelemente 120, die jeweils ausgebildet sind, um ein Sensorsignal 350 auszugeben, das einen Zustand in Bezug auf eine Magnetisierung eines sich im Messbereich 360 des Sensorelements 120 befindlichen Bereiches des Magnetelementes 110 durch einen von zumindest drei vordefinierten Sensorsignalwerten repräsentiert. Das Magnetelement 110 ist dabei in Bezug zu den Sensorelementen 120 um einen Drehpunkt 345 beweglich angeordnet und in Bezug zum Gangwahlschalter 300 unbeweglich angeordnet, um nach einer Bewegung des Gangwahlschalters 300 durch die Sensorelemente 120 eine Position des Magnetelementes 110 und folglich eine Position des Gangwahlschalters 300 erfassen zu können. Die Sensorsignale 350 werden in einer Sensorausgabeeinheit 370 zu einem Codewort als Ausgabesignal 380 verknüpft, wie es nachfolgend näher dargestellt wird. Zusätzlich kann die Sensorvorrichtung 110 eine Prüfeinheit 390, die ausgebildet ist, um eine Funktionsfähigkeit des Sensorelementes beispielsweise entsprechend der nachfolgenden Beschreibung zu testen.

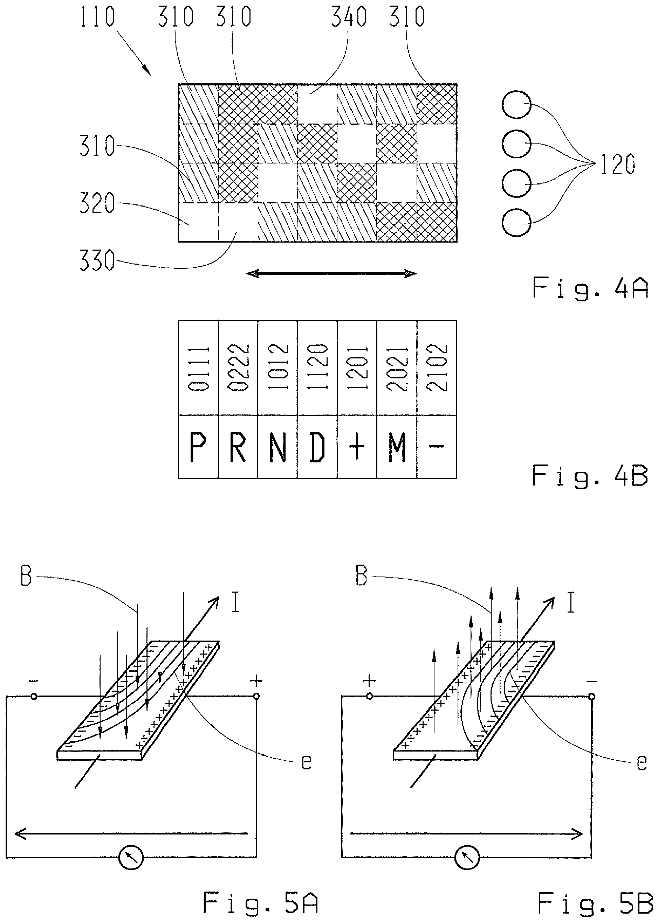

In der Fig. 4A ist eine schematische Draufsicht eines Magnetelementes 110 gemäß einem Ausführungsbeispiel der vorliegenden Erfindung gezeigt. In der Fig. 4B ist eine Tabelle des diesem bevorzugten Ausführungsbeispiel zuordbaren Schaltverhaltens dargestellt. Das Magnetelement 110 kann hierbei beispielsweise in einer Sensorvorrichtung wie der vorbeschriebenen Sensorvorrichtung 100 verwendet werden. Das Magnetelement 110 ist aus einer rechteckförmigen Magnetplatte ausgebildet, welche parallel zu wenigstens einer Richtung (in Fig. 4A dargestellte Pfeilrichtung) hin und her beweglich ist. Die Magnetfeldplatte 110 umfasst mehrere magnetisierte Bereiche 310 und nicht-magnetisierte Bereiche 320, 330, 340. Die magnetisierten Bereiche 310 umfassen unterschiedlich magnetisierte Bereich bzw. magnetisierte Bereiche unterschiedlicher Polarität. Die in der Fig. 4A gezeigte Anordnung von magnetisierten und nicht-magnetisierten Bereichen sowie die magnetisierten Bereiche mit unterschiedlicher Polarität sind nur beispielhaft gewählt und können anders angeordnet sein. Im Einzelnen umfasst die Magnetplatte 110 in der beispielhaft gezeigten Ausführungsform mehrere magnetische Nordpole, die durch die einfach schraffierten Felder in der Fig. 4A dargestellt sind. Des Weiteren umfasst die Magnetplatte 110 mehrere doppelt schraffierte Bereiche, welche einen magnetischen Südpol darstellen. Die nicht-schraffierten Felder korrespondieren zu nicht-magnetisierten Bereichen, die bei dieser bevorzugten Ausführungsform beispielhaft durch eine Kombination aus einem Loch 320, einer Ausnehmung 330 und einem diamagnetischem Material 340 verwirklicht sind. Die Magnetplatte 110 kann grundsätzlich nicht-magnetisierte Bereiche umfassen, die nur aus Löchern 320, Ausnehmungen 330 oder diamagnetischem Material oder aus einer beliebigen Kombination daraus ausgebildet sein können. Der nicht-magnetisierten Bereich führt bei diesem bevorzugten Ausführungsbeispiel zu einem Sensorsignalzustand "0", der magnetische Nordpol zu einem Sensorsignalzustand "1" und der magnetische Südpol zu einem Sensorsignalzustand "2". Auf die jeweilig erzeugbaren Sensorsignalzustände wird im Nachfolgenden insbesondere mit Bezug auf die Fig. 5 bis 5B detailliert eingegangen.

Aus dem in der Fig. 4A gezeigten Muster bzw. Anordnung der magnetisierten und nicht-magnetisierten Bereiche in Verbindung mit der vorbeschriebenen Zuordnung ergibt sich die in der Fig. 4B gezeigte Tabelle mit dem entsprechend zugeordneten Schaltschema.

Das Schaltschema wird durch ein Zusammenwirken der Magnetplatte 110 mit mehreren Sensorelementen 120, hier mit vier ternären Sensorelementen 120 erzeugt. Dabei wirkt die Magnetplatte 110 mit den ternären Sensorelementen 120 derart zusammen, dass die Magnetplatte 110 relativ beweglich zu den Sensorelementen 120 ist, wobei die Magnetplatte 110 die Sensorelemente 120 signalwirkend überfahren kann oder von diesen signalwirkend überfahrbar ist, wobei die Sensorelemente 120 im Überfahrzustand ein Sensorsignal ausgeben, das einen Zustand in Bezug auf eine Magnetisierung eines sich im Messbereich des Sensorelements 120 befindlichen Bereiches der Magnetplatte 110 durch einen von zumindest drei vordefinierten Sensorsignalwerten repräsentiert. Die Sensorsignale werden in einer Sensorausgabeeinheit zu wie in Fig. 4B gezeigten Codewörtern als Ausgabesignal verknüpft.

Eine bisher bekannte Lösung besteht darin, die Hamming-Distanz dadurch zu erhöhen, dass mehr Sensoren verwendet werden, beispielsweise sieben Sensoren statt nur vier. Der vorliegend vorgeschlagene Ansatz stellt eine alternative Lösung vor, die auf dem Hall-Effekt und der Minimalstruktur eines Hall-Sensors basiert. Dazu soll zunächst die Arbeitsweise eines HallSensors skizziert werden.

Fig. 5 zeigt die Grundlage des Hall-Effektes in zwei Teilfiguren 5A und 5B. Die Hallspannung entsteht durch einen Elektronenstrom e, der durch ein Magnetfeld bewirkt wird und der sich quer zur Flussrichtung des eingeprägten Stroms I aufbaut. In der Fig. 5A ist das Magnetfeld umgekehrt orientiert, als in der Fig. 5B. Das Vorzeichen der Spannung ist von der Richtung des Magnetfeldes und des Stromes abhängig. Gibt man in der beispielhaft gezeigten Anordnung von Fig. 5 die Stromrichtung konstruktiv vor, bleibt das magnetische Feld B als einzige Variable, um die Position des Ganghebels (wie in Fig. 1 gezeigt) zu detektieren, wenn die in Fig. 5 gezeigte Anordnungen in einem Sensor zur Erfassung der Stellung des Gangwahlhebels verbaut sind. Die Feldrichtung wird konstruktiv durch die Wahl der magnetischen Zonen auf der Magnetplatte realisiert.

Prinzipiell lassen sich also mit einem Hall-Sensor, dessen analoges Signal (hier beispielhaft mit der Signum-Funktion sgn(x) beschrieben) quantisiert wird, drei Zustände ausgeben. Beispielsweise kann bei einer Hall-Spannung $U_{Hall} > 0$ ein Wert $Sgn(U_{Hall}) = + 1$ erhalten werden, der anzeigt, dass ein Magnet am Hall-Sensor in eine Richtung weist, so dass die angreifbare Spannung positiv ist und in sich in der Nähe der positiven maximalen Hallspannung befindet. Im Fall eines Erfassens einer Hall-Spannung von $U_{Hall} \approx 0$ wird ein Vorzeichen von $U_{Hall} = 0$ erhalten, was sich derart interpretieren lässt, dass kein Magnet am Hall-Sensor anliegt, also praktisch kein magnetischer Fluss und keine Hallspannung vorhanden sind. Durch Streufelder der Magnetplatte, Umwelteinflüsse und Erdmagnetfeld sind kleine Werte ebenfalls als $U_{Hall} = 0$ zu setzen. Für den Fall, dass $U_{Hall} < 0$ gemessen wird, wird das Vorzeichen von $U_{Hall}$ mit $Sgn(U_{Hall}) = -1$ gesetzt, was sich derart interpretieren lässt, dass ein Magnet am Hall-Sensor gegenüber der zuvor genannten Ausrichtung in die andere Richtung orientiert ist. Die Spannung ist in diesem Fall negativ und liegt in der Nähe der negativen maximalen Hallspannung. Einen solchen (Hall-) Sensor mit drei Zuständen kann man auch als ternären Sensor bezeichnen.

Dem nachfolgend näher beschriebenen Ansatz liegen nun mehrere Modifikationsvorschläge zum Stand der Technik zugrunde. Beispielsweise kann der Hall-Sensor in seiner »natürlichen« Funktion betrieben werden, in der er die Richtung des Magnetfeldes über das Vorzeichen der Spannung wiedergibt. Ferner kann die Signalverarbeitung die Hallspannung nach Festlegung von Spannungsbereichen für die Hallspannung als 00 (kein Magnetfeld), 01 (Flussrichtung A), 10 (umgekehrte Flussrichtung zu A) und optional 11 (Sensor meldet Fehlerzustand) übersetzen. Weiterhin kann auch eine Magnetplatte (wie sie beispielsweise in der Fig. 1 oder Fig. 3 dargestellt ist) während oder nach der Herstellung gelocht werden, um in Verbindung mit dem Hall-Sensor den Zustand 00 darstellen zu können. Der besondere Vorteil der Schaltung liegt nun darin, dass mit der gleichen Anzahl von Sensoren eine größere Hamming-Distanz erzeugt werden kann.

Als technische Vorteile des hier vorgestellten Ansatzes kann zunächst eine technisch sehr einfache Auswertung der Wählhebelstellung erfolgen. Hierzu lassen sich mit zwei Zuständen je Sensor insgesamt 16 Codeworte realisieren. Wenn mehr als nur zwei verschiedene Codewörter je Schaltposition benötigt werden, also beispielsweise sechs Codewörter für die sechs Positionen P, R, N, D, + und -, sollte sich die Entwicklung auf eine Hamming-Distanz von zwei beschränken. Die Tabelle aus der Fig. 2 zeigt, dass es für vier Sensoren je zwei Ketten von Codes mit jeweils acht Codewörtern gibt, die untereinander eine Hamming-Distanz von mindestens zwei einhalten.

Ersetzt man die binären Hallsensoren durch die ternären Hallsensoren dieses Vorschlages, kann gemäß dem vorstehend beschriebenen Ansatz unter Verwendung der Signum-Funktion das Vorzeichen der Spannung mithilfe der Substitution:

$$b_i = sgn(U_{Hall}) + 1$$

mit

$b_i$ = Wert des i-ten Bits (ohne Einheit)
$U_{Hall}$ = gemessene Hall-Spannung in der Einheit Volt

dargestellt werden; d. h. das Alphabet des Codewortes wird aus den Sensorzuständen -1, 0, 1 in 0, 1, 2 übersetzt, um die Berechnung und Darstellung des Sensorzustandes während der Design-Phase einer Schaltung zu vereinfachen.

Mit vier "Bit" (d. h. eigentlich eher Stellen eines Codewortes), die je drei Zustände (entsprechend den Signalen eines ternären Sensors) annehmen können, lassen sich folglich $3^4 = 81$ Codeworte bilden, also über fünf Mal mehr, als mit nur zwei Zuständen. Bei der Berechnung der möglichen Hamming-Ketten zeigt sich, dass mit vier Sensoren und je drei Zuständen 72 verschiedene Ketten ergeben, die den Hamming-Abstand drei haben - wie in der Tabelle aus Fig. 2 dargestellt, kann ein binärer Sensor nur zwei Ketten liefern.

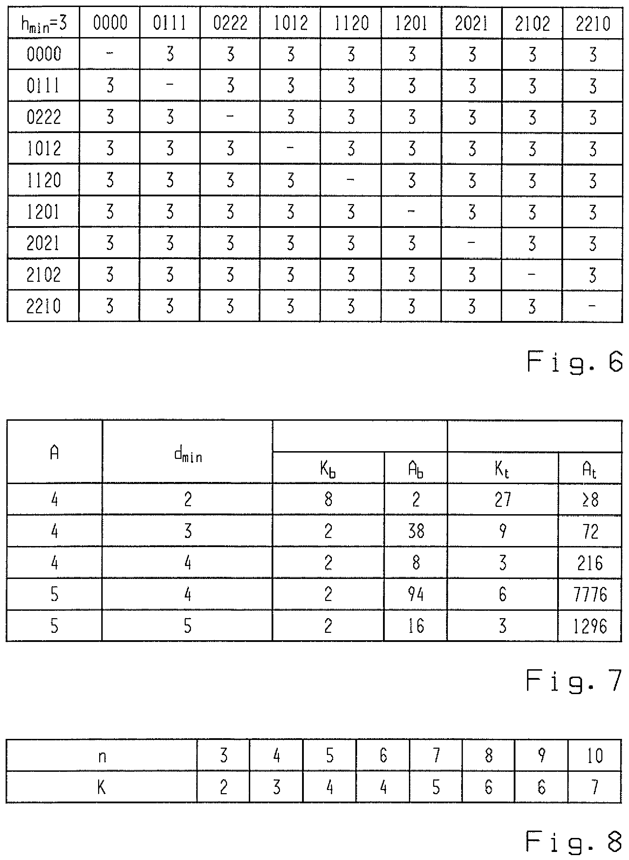

Die Tabelle aus Fig. 6 zeigt Beispielmuster für Hamming-Ketten mit einer Hamming-Distanz $h_{min} = 3$ bei Verwendung eines ternären Sensors. Insbesondere zeigt das Beispiel eine Hamming-Kette 0000 - 0111 - 0222 - 1012 - 1120 - 1201-2021 - 2102 - 2210, bei der jedes Codewort von jedem anderen genau den Hamming-Abstand von drei hat:

Die Tabelle aus Fig. 7 zeigt einen Vergleich, welche Möglichkeiten ein ternärer Sensor (d. h. der drei Zustände 0/1/2 liefert) gegenüber einem binären Sensor (d.h. der zwei Zustände 0/1 liefert) bietet, wobei in der ersten Spalte die Anzahl A der Sensoren, in der zweiten Spalte die minimal geforderte Hamming-Distanz $d_{min}$, in der dritten Spalte die Kettenlänge $K_b$ und die Anzahl $A_b$ für den Fall eines binären Sensors und in der vierten Spalte die Kettenlänge $K_t$ und die Anzahl $A_t$ für den Fall einer ternären Sensors wiedergegeben ist. Die Tabelle aus der Fig. 7 zeigt folglich einen Vergleich der Ausbeute bei verschiedenen Sensortypen. Je größer die Kettenlänge ist, umso mehr unterschiedliche Schaltbefehle (P, R, N, D, +, - und weitere) können einem Codewort zugewiesen werden und gleichzeitig die geforderte und vorteilhafte minimale Hamming-Distanz erreichen.

Alternativ bietet die Tabelle aus der Fig. 7 auch einen Überblick, wie die Anzahl der Sensoren bei gleicher Leistung des Sensorsystems reduziert werden kann. Da ein Sensorsystem mit drei Zuständen je Sensor mehr verschiedene Codewörter liefert, als ein Sensorsystem mit nur zwei Zuständen je Sensor, kann die Zahl der Sensoren bei gleicher Funktion und unverändertem Nutzen für Sicherheit und Verfügbarkeit reduziert werden.

Die Reduzierung berechnet sich nach der Gleichung

$$k \geq n \cdot \frac{\ln 2}{\ln 3}$$

mit

k = Anzahl der benötigten ternären Sensoren (mit drei Zuständen) und
n = Anzahl der vorhandenen binären Sensoren (mit zwei Zuständen)

In der Tabelle aus Fig. 8 ist ein Ergebnis dargestellt, in der die Anzahl der Sensoren, die bei Umbau von binären auf ternäre Sensoren eingespart werden können, wobei in der oberen Zeile die Sensoren für das alte Layout mit binären Signalen $2^n$ aufgetragen sind und in der unteren Zeile die Anzahl von erforderlichen Sensoren bei Verwendung den neuen Layout eingetragen ist, d. h. von Sensoren mit $3^k$ unterschiedliche Zuständen pro Sensorwert, die erforderlich sind, um einen Codewortraum zu erhalten, der dem Codewartraum bei der Verwendung von binären Sensoren entspricht.

Ein weiterer technischer Vorteil des hier vorgeschlagenen Ansatzes ist in der Möglichkeit einer verbesserten Diagnose zu sehen. Eine weitere häufig gestellte Forderung ist die permanente Diagnose des Systems. Bei Sensoren mit drei Zuständen bietet sich eine weitere Möglichkeit, die Diagnose auszuführen: Steht über dem Hall-Sensor ein Pol ("nordmagnetisch" oder "südmagnetisch") kann der Sensor beispielsweise dadurch überprüft werden, dass die konstruktiv vorgegebene Stromrichtung I (beispielsweise wie sie in den Teilfiguren der Fig. 5 zu erkennen ist) zur Diagnose abgeschaltet und dann umgekehrt wird. Ein korrekt arbeitender Sensor folgt dem, indem zunächst die Hallspannung verschwindet und dann mit umgekehrtem Vorzeichen wieder am Sensor anliegt. Für den Fall, dass bei der Umkehrung des Stromflusses kein solches Sensorergebnisverhalten zu beobachten ist, kann darauf rückgeschlossen werden, dass der betreffende Sensor defekt ist.

Als weiterer technischer Vorteil kann eine besondere Magnetplatte genannt werden, die zur Unterstützung der Funktion des hier vorgestellten Ansatzes eingesetzt werden kann. Diese Magnetplatte, wie sie beispielsweise in der Fig. 1 und 4A dargestellt ist, kann beispielsweise durch Lochung in Verbindung mit dem vor der Lochung positionierten Hall-Sensor den magnetfeldfreien Zustand "00" darstellen. Um besonders kompakte Magnetplatten zu bauen oder um einen besonders scharfen Übergang zwischen magnetischem und nichtmagnetischem Bereich zu erreichen, können die Löcher in den Platten mit einem diamagnetischen Einsatz ($\mu_r < 1$, beispielsweise Kupfer) bestückt werden. Alternativ kann die Magnetplatte aus einzelnen Stücken oder Magneten zusammengesetzt werden, die ihrerseits auf einen Blechträger gesetzt werden. Wenn die Sensoren nur auf einer Seite angebracht sind, weist diese Anordnung keinen Nachteil auf, wenn eine durchgehende Blechplatte verwendet wird, um die magnetischen Stücke großflächig aufzukleben.

Die Umsetzung des hier vorgestellten Ansatzes eröffnet eine Reihe von Vorteilen. Zum einen lässt sich eine konstruktive Überarbeitung von bestehenden Sensorsystemen vornehmen, bei der binäre durch ternäre Sensoren ersetzt werden können und mit einer Magnetplatte mit drei Zuständen "nordmagnetisch", "südmagnetisch" und "nicht magnetisch" kombiniert werden können. Daraus ergibt sich ein Nutzwert bei gleicher Sensorenzahl, da im Zielkonflikt der Abwägung einer Auswertungssicherheit der Sensorergebnisse gegen eine Verfügbarkeit der Sensorergebnisse sich das herzustellende Sensorsystem besser auf die Anforderungen eines Kunden zuschneiden lässt, indem entweder ein höheres Sicherheitslevel (SIL/ASIL) erreicht wird oder die Verfügbarkeit verbessert wird. Als weiterer Nutzwert kann genannt werden, dass bei der Überarbeitung bestehender Lösungen keine Änderung des Packagings (d. h. die Anordnung der Sensoren in einem Sensorgehäuse erforderlich wäre und die Übernahme vieler Komponenten bei nur mäßigem Anpassungsaufwand möglich wird. Alternativ können bei gleicher Sicherheit/Verfügbarkeit Sensoren eingespart werden.

Ferner bietet der vorliegende Ansatz einen diagnostischen Vorteil, da es eine weitere Möglichkeit gibt, den Sensor sofort auf seine korrekte Funktion hin zu überprüfen.

In Bezug auf die besondere Magnetplatte lässt sich anmerken, dass die Zusammenfügung einzelner Magnete oder Stücke von Magnetplatten auf einem Blechträger die Freiheiten bei der Ausgestaltung der Magnetplatte (d. h. Anordnung und Größe der einzelnen Pole) verbessern kann und Kosten und Prozesszeiten bei der Herstellung der Magnetplatte senken.

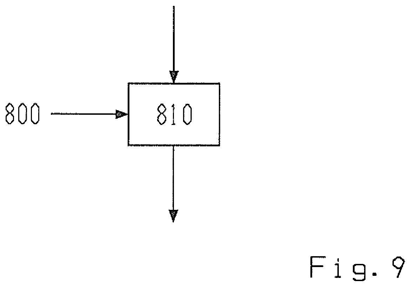

Fig. 9 zeigt ein Ablaufdiagramm eines Ausführungsbeispiels der vorliegenden Erfindung als Verfahren 800 zur Erfassung einer Position des Magnetelementes in Bezug zu einem Sensorelement, wobei das Verfahren 800 eine Sensorvorrichtung entsprechend einem vorstehend beschriebenen Ausführungsbeispiel verwendet. Das Verfahren 800 umfasst einen Schritt des Ausgebens 810 eines Sensorsignals, das einen Zustand in Bezug auf eine Magnetisierung eines sich im Messbereich des Sensorelements befindlichen Bereiches des Magnetelementes durch einen von zumindest drei vordefinierten Sensorsignalwerten repräsentiert.

Zusammenfassend sollen im Folgenden die wichtigsten Merkmale des hier vorgestellten Ansatzes nochmals herausgestellt werden. Zunächst wird die Verwendung eines oder mehrerer ternärer Sensoren zur Erfassung der Schalthebelstellung vorgeschlagen. Dabei weist eine Schalteinrichtung, insbesondere für Kraftfahrzeuge, eine magnetische Vorrichtung mit einem oder mehreren Bereichen, die eine Magnetisierung aufweisen können, und einem Sensor auf, der eine vorhandene Magnetisierung erkennen und die Richtung dieser Magnetisierung bestimmen kann. Dabei kann günstigerweise die Magnetplatte von einer Seite eine Kombination von wenigstens einen der zwei möglichen Zustände "nordmagnetisch" und "südmagnetisch" mit dem Zustand "nicht magnetisiert" kombiniert werden. Zugleich lassen sich in dieser Magnetplatte die nicht-magnetisierten Bereiche durch Löcher realisieren. Zur Überprüfung der korrekten Funktion eines solchen Sensors kann eine Vorrichtung vorgesehen werden, die durch Umkehrung der Stromrichtung im Hallsensor die Funktion des Hallsensors prüfen kann.

Gemäß einem anderen Aspekt der vorliegenden Erfindung ist eine Magnetplatte vorgesehen, die für einen einseitig angebrachten Sensor drei Zustände aufweist, nämlich den Zustand "nordmagnetisch", den Zustand "südmagnetisch" und den Zustand "Loch" (d. h., dass in diesem Zustand kein Magnetfeld vom Sensor erfasst werden kann). In einer besonderen Form kann die Magnetplatte in den Löchern einen diamagnetischen Einsatz enthalten um die magnetischen Bereiche so abzuschirmen, dass ihre Streufelder aus der nichtmagnetisierten Zone geschwächt oder hinausgedrängt werden. Alternativ oder zusätzlich kann die Magnetplatte nicht aus einem Stück bestehen, sondern deren Bestandteile durch einen Träger, insbesondere umgeformten Blech, zusammengehalten oder auf ihm befestigt werden, wobei die nichtmagnetischen Bereich als Löcher des Trägers realisiert werden können. Auch in diesem Fall kann die Magnetplatte mit diamagnetischen Einsätzen in den Löchern bzw. Zwischenräumen zwischen den einzelnen magnetischen Bestandteilen der Magnetplatte versehen werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder" Verknüpfung zwischen einem ersten Merkmal und einem zweiten Merkmal, so kann dies so gelesen werden, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

Bezugszeichen

| | |
|---|---|
| 100 | Sensorvorrichtung |
| 110 | Magnetplatte, Magnetelement |
| 120 | Sensorelement |
| 300 | Gangwahlschalter, Wählhebel |
| 310 | magnetisierte Bereiche des Magnetelementes |
| 315 | Dauermagnete |
| 320 | Löcher |
| 330 | Ausnehmung |
| 340 | diamagnetisches Material |
| 345 | Drehpunkt |
| 350 | Sensorsignale, Sensorsignalleitungen |
| 360 | Messbereich |

370    Ausgabeeinheit
380    Codewort, Ausgabesignal
390    Prüfeinheit

800    Verfahren zur Erfassung einer Position des Magnetelementes in Bezug zu einem Sensorelement
810    Schritt des Ausgebens

$U_H$    Hallspannung
B      Magnetfeld
e      Elektronenfluss
I      Stromfluss

**Patentansprüche**

1.  Sensorvorrichtung (100) mit zumindest einem Sensorelement (120), insbesondere einem Hallsensorelement, und zumindest einem in Bezug zum Sensorelement (120) beweglichen Magnetelement (110), das eine Mehrzahl von unterschiedlich magnetisierten Bereichen (310) und zumindest eine Öffnung (320) und/oder Ausnehmung (330) zwischen zwei magnetisierten Bereichen (310) aufweist, wobei das Sensorelement (120) ausgebildet ist, um ein Sensorsignal (350) auszugeben, das einen Zustand in Bezug auf eine Magnetisierung eines sich im Messbereich (360) des Sensorelements (120) befindlichen Bereiches des Magnetelementes (110) durch einen von zumindest drei vordefinierten Sensorsignalwerten repräsentiert, **dadurch gekennzeichnet, dass** in der Öffnung (320) und/oder der Ausnehmung (330) ein diamagnetisches Material (340) angeordnet ist.

2.  Sensorvorrichtung (100) gemäß Anspruch 1, **dadurch gekennzeichnet, dass** das Sensorelement (120) ausgebildet ist, um einen vordefinierten Sensorsignalwert als Sensorsignal (350) bereitzustellen, wenn in einem Zustand in Bezug auf eine Magnetisierung des sich im Messbereich (360) des Sensorelements (120) befindlichen Bereiches des Magnetelementes (110), kein magnetischer Fluss (B) auf das Sensorelement (120) wirkt.

3.  Sensorvorrichtung (100) gemäß einem der vorangegangen Ansprüche, **dadurch gekennzeichnet, dass** das Sensorelement (120) ausgebildet ist, um ein Sensorsignal (350) mit einem Sensorsignalwert bereitzustellen, aus dem die Orientierung eines Magnetfeldes (B) an dem sich im Messbereich (360) des Sensorelements (120) befindlichen Bereiches des Magnetelementes (110) erkennbar ist, nicht jedoch eine Stärke des Magnetfeldes (B) an dem sich im Messbereich (360) des Sensorelements (120) befindlichen Bereiches des Magnetelementes (110).

4.  Sensorvorrichtung (100) gemäß einem der vorangegangen Ansprüche, **dadurch gekennzeichnet, dass** die Sensorvorrichtung (100) zumindest ein weiteres Sensorelement (120), insbesondere ein weiteres Hallsensorelement, aufweist, wobei das weitere Sensorelement (120) ausgebildet ist, um ein weiteres Sensorsignal (250) auszugeben, das einen Zustand in Bezug auf eine Magnetisierung eines sich im Messbereich (360) des weiteren Sensorelement (120) befindlichen Bereiches des Magnetelementes (110) durch einen von zumindest drei vordefinierten Sensorsignalwerten repräsentiert.

5.  Sensorvorrichtung (100) gemäß Anspruch 4, **gekennzeichnet, durch** eine Signalausgabeeinheit (370), die ausgebildet ist, um den Sensorsignalwert des Sensorsignals (350) des Sensorelementes (120) mit zumindest dem Sensorsignalwert des weiteren Sensorsignals (350) des zumindest einen weiteren Sensorelementes (120) zu einem Sensorsignalwort (380) zu verknüpfen, wobei die Signalausgabeeinheit (370) ferner ausgebildet ist, um für unterschiedliche relative Positionen des Magnetelementes (110) in Bezug zum Sensorelement (120) und dem weiteren Sensorelement (120) Sensorsignalworte (380) auszugeben, die einen Hamming-Abstand von mindestens zwei, insbesondere die einen Hamming-Abstand von mindestens drei aufweisen.

6.  Sensorvorrichtung (100) gemäß einem der vorangegangen Ansprüche, **dadurch gekennzeichnet, dass** das diamagnetische Material (340) Kupfer ist.

7.  Sensorvorrichtung (100) gemäß einem der vorangegangen Ansprüche, **dadurch gekennzeichnet, dass** das Magnetelement (110) mehrere Teilelemente (310, 340) aufweist, wobei zumindest ein teilweise planares Trägerelement vorgesehen ist, auf dem magnetische Teilelemente (315) angeordnet sind.

8.  Sensorvorrichtung (100) gemäß einem der vorangegangen Ansprüche, **gekennzeichnet, durch** eine Sensorprüfeinheit (390), die ausgebildet ist, um eine Richtung eines Stromflusses (I) **durch** das Sensorelement (120) zu verändern und auf der Basis eines Sensorsignalwerts eines nach verändertem Stromfluss (I) **durch** das Sensorelement (120) erfassten Sensorsignals (350) eine korrekte Funktion des Sensorelementes (120) zu erkennen.

9.  Schalteinrichtung, insbesondere für ein Kraftfahrzeug, **gekennzeichnet, durch** eine Sensorvorrichtung (100) gemäß einem der vorangegangen Ansprüche, wobei die Sensorvorrichtung (100) ausgebildet ist, um eine Stellung eines Schalthebels, insbesondere eines Gangschalthebels (300), zu erfassen.

**10.** Verfahren (800) zur Erfassung einer Position des Magnetelementes in Bezug zu einem Sensorelement, wobei das Verfahren eine Sensorvorrichtung gemäß einen der Ansprüche 1 bis 9 verwendet, **gekennzeichnet durch** den folgenden Schritt:

- Ausgeben (810) eines Sensorsignals, das einen Zustand in Bezug auf eine Magnetisierung eines sich im Messbereich des Sensorelements befindlichen Bereiches des Magnetelementes **durch** einen von zumindest drei vordefinierten Sensorsignalwerten repräsentiert.

**11.** Magnetelement (110) für eine Sensorvorrichtung (100) gemäß einem der Ansprüche 1 bis 9, aufweisend eine Mehrzahl von magnetisierten Bereichen (310) und wenigstens einen nicht-magnetisierten (320; 330) und diamagnetischen Bereich (340) angrenzend zu wenigstens zwei magnetisierten Bereichen (310), wobei der nicht-magnetisierte Bereich (320; 330) wenigstens eine Öffnung (320) und/oder Ausnehmung (330) aufweist, wobei der diamagnetische Bereich ein mit dem Magnetelement (110) ausgebildetes oder auf dem Magnetelement (110) angeordnetes diamagnetisches Material (340) aufweist, **dadurch gekennzeichnet, dass** das diamagnetische Material (340) in der Öffnung (320) und/oder Ausnehmung (330) angeordnet ist.

## Claims

**1.** Sensor apparatus (100) having at least one sensor element (120), in particular a Hall sensor element, and at least one magnetic element (110) which is movable with respect to the sensor element (120) and has a plurality of differently magnetized regions (310) and at least one opening (320) and/or recess (330) between two magnetized regions (310), the sensor element (120) being designed to output a sensor signal (350) which represents a state with respect to magnetization of a region of the magnetic element (110) which is in the measurement range (360) of the sensor element (120) by means of one of at least three predefined sensor signal values, **characterized in that** a diamagnetic material (340) is arranged in the opening (320) and/or the recess (330).

**2.** Sensor apparatus (100) according to Claim 1, **characterized in that** the sensor element (120) is designed to provide a predefined sensor signal value as the sensor signal (350) if a magnetic flux (B) does not act on the sensor element (120) in a state with respect to magnetization of that region of the magnetic element (110) which is in the measurement range (360) of the sensor element (120).

**3.** Sensor apparatus (100) according to one of the preceding claims, **characterized in that** the sensor element (120) is designed to provide a sensor signal (350) having a sensor signal value from which it is possible to discern the orientation of a magnetic field (B) **in that** region of the magnetic element (110) which is in the measurement range (360) of the sensor element (120), but not a strength of the magnetic field (B) **in that** region of the magnetic element (110) which is in the measurement range (360) of the sensor element (120).

**4.** Sensor apparatus (100) according to one of the preceding claims, **characterized in that** the sensor apparatus (100) has at least one further sensor element (120), in particular a further Hall sensor element, the further sensor element (120) being designed to output a further sensor signal (250) which represents a state with respect to magnetization of a region of the magnetic element (110) which is in the measurement range (360) of the further sensor element (120) by means of one of at least three predefined sensor signal values.

**5.** Sensor apparatus (100) according to Claim 4, **characterized by** a signal output unit (370) which is designed to link the sensor signal value of the sensor signal (350) from the sensor element (120) to at least the sensor signal value of the further sensor signal (350) from the at least one further sensor element (120) to form a sensor signal word (380), the signal output unit (370) also being designed to output sensor signal words (380) for different relative positions of the magnetic element (110) with respect to the sensor element (120) and the further sensor element (120), which sensor signal words have a Hamming distance of at least two, in particular a Hamming distance of at least three.

**6.** Sensor apparatus (100) according to one of the preceding claims, **characterized in that** the diamagnetic material (340) is copper.

**7.** Sensor apparatus (100) according to one of the preceding claims, **characterized in that** the magnetic element (110) has a plurality of partial elements (310, 340), at least one partially planar carrier element being provided, on which magnetic partial elements (315) are arranged.

**8.** Sensor apparatus (100) according to one of the preceding claims, **characterized by** a sensor checking unit (390) which is designed to change a direction of a current flow (I) through the sensor element (120) and to detect a correct function of the sensor element (120) on the basis of a sensor signal value of a sensor signal (350) sensed after a changed current flow (I) through the sensor element (120).

**9.** Switching device, in particular for a motor vehicle, **characterized by** a sensor apparatus (100) according to one of the preceding claims, the sensor apparatus (100) being designed to sense a position of a shift lever, in particular a gearshift lever (300).

**10.** Method (800) for sensing a position of the magnetic element with respect to a sensor element, the method using a sensor apparatus according to one of Claims 1 to 9, **characterized by** the following step of:

- outputting (810) a sensor signal which represents a state with respect to magnetization of a region of the magnetic element which is in the measurement range of the sensor element by means of one of at least three predefined sensor signal values.

**11.** Magnetic element (110) for a sensor apparatus (100) according to one of Claims 1 to 9, having a plurality of magnetized regions (310) and at least one non-magnetized region (320; 330) and a diamagnetic region (340) adjacent to at least two magnetized regions (310), the non-magnetized region (320; 330) having at least one opening (320) and/or recess (330), the diamagnetic region having a diamagnetic material (340) which is formed with the magnetic element (110) or is arranged on the magnetic element (110), **characterized in that** the diamagnetic material (340) is arranged in the opening (320) and/or recess (330).

**Revendications**

**1.** Dispositif capteur (100) comportant au moins un élément capteur (120), notamment un élément capteur à effet Hall, et au moins un élément à aimant (110) mobile par rapport à l'élément capteur (120), qui comporte une pluralité de zones magnétisées de manière différente (310) et au moins une ouverture (320) et/ou un évidement (330) entre deux zones magnétisées (310), dans lequel l'élément capteur (120) est conçu pour délivrer un signal de capteur (350) qui représente un état par rapport à une magnétisation d'une zone de l'élément magnétique (110) se trouvant dans la zone de mesure (360) de l'élément capteur (120), par l'une d'au moins trois valeurs de signal de capteur prédéfinies, **caractérisé en ce qu'**un matériau diamagnétique (340) est disposé dans l'ouverture (320) et/ou dans l'évidement (330).

**2.** Dispositif capteur (100) selon la revendication 1, **caractérisé en ce que** l'élément capteur (120) est conçu pour fournir une valeur de signal de capteur prédéfinie en tant que signal de capteur (350) lorsqu'aucun flux magnétique (B) n'agit sur l'élément capteur (120) dans un état par rapport à une magnétisation de la zone de l'élément à aimant (110) se trouvant dans la zone de mesure (360) de l'élément capteur (120).

**3.** Dispositif capteur (100) selon l'une quelconque des revendications précédentes, **caractérisé en ce que** l'élément capteur (120) est conçu pour fournir un signal de capteur (350) ayant une valeur de signal de capteur, à partir duquel il est possible de détecter l'orientation d'un champ magnétique (B) au niveau de la zone de l'élément à aimant (110) se trouvant dans la zone de mesure (360) de l'élément capteur (120) sans pouvoir cependant détecter l'intensité du champ magnétique (B) au niveau de la zone de l'élément à aimant (110) se trouvant dans la zone de mesure (360) de l'élément capteur (120).

**4.** Dispositif capteur (100) selon l'une quelconque des revendications précédentes, **caractérisé en ce que** le dispositif capteur (100) comporte au moins un autre élément capteur (120), notamment un autre élément capteur à effet Hall, dans lequel l'autre élément capteur (120) est conçu pour délivrer un autre signal de capteur (250) qui représente un état par rapport à une magnétisation d'une zone de l'élément à aimant (110) se trouvant dans la zone de mesure (360) de l'autre élément capteur (120), par l'une d'au moins trois valeurs de signal de capteur prédéfinies.

**5.** Dispositif capteur (100) selon la revendication 4, **caractérisé par** une unité de sortie de signal (370) qui est conçue pour combiner la valeur de signal de capteur du signal de capteur (350) de l'élément capteur (120) à au moins la valeur de signal de capteur de l'autre signal de capteur (350) de l'au moins un autre élément capteur (120) en un mot de signal de capteur (380), dans lequel l'unité de sortie de signal (370) est en outre conçue pour délivrer, pour des positions relatives différentes de l'élément à aimant (110) par rapport à l'élément capteur (120) et à l'autre élément capteur (120), des mots de signal de capteur (380) qui présentent une distance de Hamming au moins égale à deux, et en particulier, qui présentent une distance de Hamming au moins égale à trois.

**6.** Dispositif capteur (100) selon l'une quelconque des revendications précédentes, **caractérisé en ce que** le matériau diamagnétique (340) est le cuivre.

**7.** Dispositif capteur (100) selon l'une quelconque des revendications précédentes, **caractérisé en ce que** l'élément à aimant (110) comporte plusieurs éléments partiels (310, 340), dans lequel il est prévu au moins un élément de support partiellement plan sur lequel sont disposés des éléments partiels magnétiques (315).

8. Dispositif capteur (100) selon l'une quelconque des revendications précédentes, **caractérisé par** une unité de test de capteur (390) qui est conçue pour modifier une direction d'un flux de courant (I) à travers l'élément capteur (120) et pour détecter, sur la base d'une valeur de signal de capteur d'un signal de capteur (350) détecté après modification du flux de courant (I) à travers l'élément capteur (120), un fonctionnement correct de l'élément capteur (120).

9. Dispositif de commutation, notamment destiné à un véhicule automobile, **caractérisé par** un dispositif capteur (100) selon l'une quelconque des revendications précédentes, dans lequel le dispositif capteur (100) est conçu pour détecter une position d'un levier de commutation, notamment d'un levier de changement de rapport (300).

10. Procédé (800) destiné à détecter une position d'un élément à aimant par rapport à un élément capteur, dans lequel le procédé utilise un dispositif capteur selon l'une quelconque des revendications 1 à 9, **caractérisé par** l'étape consistant à :

    - délivrer (810) un signal de capteur qui représente un état par rapport à une magnétisation d'une zone de l'élément à aimant se trouvant dans la zone de mesure de l'élément capteur, par l'une d'au moins trois valeurs de signal de capteur prédéfinies.

11. Eléments à aimant (110) destiné à un dispositif capteur (100) selon l'une quelconque des revendications 1 à 9, comportant une pluralité de zones magnétisées (310) et au moins une zone non magnétisée (320 ; 330) et diamagnétique (340) adjacente à au moins deux zones magnétisées (310), dans lequel la zone non magnétisée (320 ; 330) comporte au moins une ouverture (320) et/ou un évidement (330), dans lequel la zone diamagnétique comporte un matériau diamagnétique (340) réalisé avec l'élément à aimant (110) ou disposé sur l'élément à aimant (110), **caractérisé en ce que** le matériau diamagnétique (340) est disposé dans l'ouverture (320) et/ou dans l'évidement (330).

Fig. 1

| | | 1 | 2 | 3 | 4 | 5 | 6 | 7 | 8 |
|---|---|---|---|---|---|---|---|---|---|
| | A | 0000 | 0011 | 0101 | 0110 | 1001 | 1010 | 1100 | 1111 |
| | B | 0001 | 0010 | 0100 | 0111 | 1000 | 1011 | 1101 | 1110 |

Fig. 2

Fig. 3

Fig. 4A

| 0111 | 0222 | 1012 | 1120 | 1201 | 2021 | 2102 |
|------|------|------|------|------|------|------|
| P | R | N | D | + | M | − |

Fig. 4B

Fig. 5A

Fig. 5B

| $h_{min}=3$ | 0000 | 0111 | 0222 | 1012 | 1120 | 1201 | 2021 | 2102 | 2210 |
|---|---|---|---|---|---|---|---|---|---|
| 0000 | – | 3 | 3 | 3 | 3 | 3 | 3 | 3 | 3 |
| 0111 | 3 | – | 3 | 3 | 3 | 3 | 3 | 3 | 3 |
| 0222 | 3 | 3 | – | 3 | 3 | 3 | 3 | 3 | 3 |
| 1012 | 3 | 3 | 3 | – | 3 | 3 | 3 | 3 | 3 |
| 1120 | 3 | 3 | 3 | 3 | – | 3 | 3 | 3 | 3 |
| 1201 | 3 | 3 | 3 | 3 | 3 | – | 3 | 3 | 3 |
| 2021 | 3 | 3 | 3 | 3 | 3 | 3 | – | 3 | 3 |
| 2102 | 3 | 3 | 3 | 3 | 3 | 3 | 3 | – | 3 |
| 2210 | 3 | 3 | 3 | 3 | 3 | 3 | 3 | 3 | – |

Fig. 6

| A | $d_{min}$ | $K_b$ | $A_b$ | $K_t$ | $A_t$ |
|---|---|---|---|---|---|
| 4 | 2 | 8 | 2 | 27 | $\geq 8$ |
| 4 | 3 | 2 | 38 | 9 | 72 |
| 4 | 4 | 2 | 8 | 3 | 216 |
| 5 | 4 | 2 | 94 | 6 | 7776 |
| 5 | 5 | 2 | 16 | 3 | 1296 |

Fig. 7

| n | 3 | 4 | 5 | 6 | 7 | 8 | 9 | 10 |
|---|---|---|---|---|---|---|---|---|
| K | 2 | 3 | 4 | 4 | 5 | 6 | 6 | 7 |

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5880683 A
- JP 61133819 A
- US 6404188 B1
- DE 1438899 A1
- US 5880913 A
- EP 0212628 A2
- EP 1003186 A1